# EUROPEAN PATENT APPLICATION

(11) **EP 4 715 868 A1**
(43) Date of publication of application: **25.03.2026**
(21) Application number: 24806438.8
(22) Date of filing: 09.05.2024
(51) Int. Cl.: H01L 21/67, H01L 21/677, H01L 31/18

(54) **SEMICONDUCTOR HEAT TREATMENT DEVICE AND CARRYING DEVICE TRANSMISSION METHOD THEREOF**

(30) Priority: 15.05.2023 CN 202310540517
(71) Applicant: Beijing NAURA Microelectronics Equipment Co., Ltd., Beijing 100176 (CN)
(72) Inventor: CAO, Jingyang, Beijing 100176 (CN); ZHANG, Qiang, Beijing 100176 (CN); ZHAO, Fuping, Beijing 100176 (CN); SHEN, Zhen, Beijing 100176 (CN); LI, Buzhong, Beijing 100176 (CN); ZHENG, Jianyu, Beijing 100176 (CN); GENG, Dan, Beijing 100176 (CN); LIU, Aixu, Beijing 100176 (CN)
(74) Representative: Cohausz & Florack
(86) International application number: PCT/CN2024/091867
(87) International publication number: WO 2024/235086

(57) **Abstract**

A semiconductor thermal processing apparatus and a method for transferring workpieces by a carrier device are disclosed. The apparatus includes process chambers assigned into one or more chamber groups; one or more carrier devices associated one-to-one to one of the chamber groups; one or more transfer actuators, each of the transfer actuators being connected to one carrier device in a one-to-one correspondence and configured to drive the connected carrier device to perform a transfer-in or transfer-out action; a controller, communicatively connected to the transfer actuators, receives a transfer-in or transfer-out instruction to a designated process chamber, and, according to the transfer-in or transfer-out instruction, to control the transfer actuator associated to the chamber group assigned to the designated process chamber to perform the transfer-in or transfer-out action; and a host computer, communicatively connected to the controller, transmits the transfer-in or transfer-out instruction to the controller using a preset scheduling method.

## Description

### FIELD OF TECHNOLOGY

The present disclosure relates to the technical field of semiconductor thermal processing apparatus, and more particularly, to a semiconductor thermal processing apparatus and a method for transferring workpieces by a carrier device thereof.

### BACKGROUND

In developing photovoltaic manufacturing equipment (for example, semiconductor thermal processing apparatus such as horizontal diffusion furnaces) toward "large capacity and low cost," the number of cantilever paddles (used for carrying wafers or other workpieces to be processed) included in a single photovoltaic manufacturing equipment has increased from two in the past to the current five to six as mainstream. The cantilever paddle is one of the core components of the thermal processing apparatus to process photovoltaic semiconductor parts, and rapid and efficient automatic control and scheduling of the cantilever paddle is an indispensable key technology for cost reduction and efficiency improvement of the thermal processing apparatus for photovoltaic semiconductor parts.

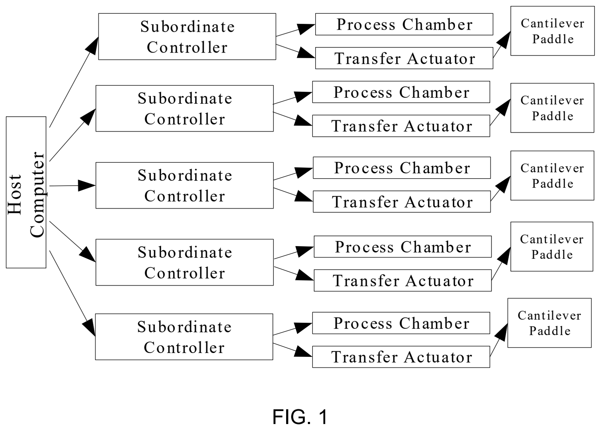

FIG. 1 is a schematic block diagram of control devices of multiple conventional cantilever paddles. As shown in FIG. 1, the semiconductor thermal processing apparatus includes multiple process chambers (for example, furnace tubes), each of the process chambers being provided with a subordinate controller, a transfer actuator, and a cantilever paddle, all connected to a host computer. The host computer transmits a series of individual commands such as paddle forward, paddle down, paddle backward, and furnace door closing to each subordinate controller, so that each subordinate controller independently drives the transfer actuator to control the transfer of photovoltaic semiconductor workpiece by the cantilever paddle. The transfer actuator is configured to drive the cantilever paddle to move vertically and to translate, which transfers the photovoltaic semiconductor workpiece into or out of the associated process chamber.

However, the above control device inevitably has the following problems in practical applications:
(1) Each parallel subordinate controller gets from the host computer a series of independent commands, to control the transfer actuator and the cantilever paddle, such as paddle forward, paddle down, paddle backward, and furnace door closing, etc. Such a stepwise control mode has a relatively low degree of automation and scheduling efficiency, so it cannot meet the speed requirements of highly automated control.
(2) Limited by the overall equipment energy consumption, a full-capacity operation is generally not adopted, i.e., not all cantilever paddles can work in parallel simultaneously. However, to equip each of the process chambers with more than one cantilever paddle and transfer actuator would cause structural redundancy, plus increase costs in equipment manufacturing and maintenance. Meanwhile, standby cantilever paddles add overall equipment energy consumption.

### SUMMARY

The present disclosure proposes a semiconductor thermal processing apparatus and a method for transferring workpieces by a carrier device thereof, thereby improving automation and scheduling efficiency, removing structural redundancy, lowering overall energy consumption, and reducing equipment manufacturing and maintenance costs.

A semiconductor thermal processing apparatus is provided, comprising:
process chambers, wherein the process chambers are assigned into one or more chamber groups;
one or more carrier devices configured to carry workpieces to be processed; wherein each of the carrier devices is in a one-to-one correspondence with one chamber group;
one or more transfer actuators, wherein each of the transfer actuators is in a one-to-one correspondence with one associated carrier device and is configured to drive the associated carrier device to perform a transfer-in action or a transfer-out action; wherein the transfer-in action or the transfer-out action is configured to move the carrier device into or out of any process chamber of the assigned chamber group;
a controller communicatively connected to all the transfer actuators, wherein the controller is configured to receive a transfer-in instruction or a transfer-out instruction associated with a designated process chamber, and to control the associated transfer actuator assigned to the chamber group that the designated process chamber is associated with in order to perform the transfer-in action or the transfer-out action according to the transfer-in instruction or the transfer-out instruction; and
a host computer communicatively connected to the controller, wherein the host computer is configured to transmit the transfer-in instruction or the transfer-out instruction to the controller using a preset scheduling method.

In some embodiments, the semiconductor thermal processing apparatus further comprises:
one or more braking mechanisms, wherein each of the braking mechanisms is arranged in a one-to-one correspondence with a carrier device and is configured to brake the associated carrier device when receiving a braking signal, and to release the braking at the associated carrier device when receiving a braking release signal;
wherein the controller is further configured to transmit the braking signal or the braking release signal to the braking mechanisms.

In some embodiments, each of the braking mechanisms comprises:
a locking cylinder;
a clamp connected to a piston rod of the locking cylinder, wherein the clamp is configured to brake the associated carrier device when the piston rod extends out from the locking cylinder, and to release the braking of the associated carrier device when the piston rod retracts; and
a control air circuit connected to the locking cylinder, wherein the control air circuit is configured to supply air to the locking cylinder when receiving the braking signal so as to extend the piston rod from the locking cylinder, and to discharge gas in the locking cylinder when receiving the braking release signal so as to retract the piston rod.

In some embodiments, an interior of the locking cylinder is divided by the piston rod into a first air chamber and a second air chamber, and one end of the piston rod passes through the second air chamber and extends out of the locking cylinder.

In some embodiments, the control air circuit comprises a directional valve, a relief valve, and an air source, wherein the air source is connected to the directional valve through a first air line, the relief valve is connected to the directional valve through a second air line, and the directional valve is connected to the first air chamber through a third air line, and to the second air chamber through a fourth air line, respectively.

Herein, the directional valve is configured to switch to a first state when receiving the braking signal, and switch to a second state when receiving the braking release signal; in the first state, the directional valve connects the first air line with the third air line and disconnects the second air line from the fourth air line; in the second state, the directional valve connects the second air line with the third air line and disconnects the first air line from the fourth air line.

In some embodiments, the process chambers are sequentially arranged along a vertical direction;
wherein each of the transfer actuators is configured to drive the connected carrier device to move vertically to reach the designated height position for the associated process chamber in the assigned chamber group, and each of the transfer actuators is further configured to move the carrier device horizontally from the previous height position into or out of the process chamber; and
wherein the braking mechanism is configured to brake the associated carrier device's vertical motion when receiving the braking signal.

In some embodiments, each of the transfer actuators comprises:
a lifting drive assembly connected to the associated carrier device and configured to drive the associated carrier device to move vertically;
a horizontal drive assembly connected to the lifting drive assembly and configured to drive the lifting drive assembly and the carrier device to move horizontally in synchronization (horizontal motion); and
a loading and unloading mechanical arm and a drive assembly configured to drive the loading and unloading mechanical arm to move vertically and horizontally, wherein the loading and unloading mechanical arm is configured to load or unload the workpiece from the carrier device under a control of the drive assembly.

In some embodiments, the controller comprises:
a first input module configured to receive first sensor feedback signals related to control of the transfer actuators; and
a control module configured to control the transfer actuators to perform the transfer-in action or the transfer-out action according to the first sensor feedback signals.

In some embodiments, the controller further comprises:
a second input module configured to receive second sensor feedback signals related to a door opening/closing state of each of the process chambers;
wherein the control module is configured to control each of the process chamber door's opening or closing action according to the second sensor feedback signals.

A method for transferring workpieces by the carrier device of the semiconductor thermal processing apparatus is also provided, the method comprising:
receiving the transfer-in instruction or the transfer-out instruction associated with the designated process chamber; and
controlling the transfer actuator connected to the designated process chamber assigned to the chamber group to perform the transfer-in action or the transfer-out action according to the transfer-in instruction or the transfer-out instruction;
wherein the transfer-in action or the transfer-out action is configured to transfer the workpieces by the carrier device into or out of the designated process chamber assigned to the chamber group.

In some embodiments, the process chambers are sequentially arranged in a vertical direction;
wherein controlling the transfer actuator to perform the transfer-in action further comprises:
controlling the transfer actuator to drive the associated carrier device to move vertically to reach a height position in the designated process chamber;
controlling the chamber door of the designated process chamber to open; and
; controlling the associated transfer actuator to drive the connected carrier device located at the height position to move in translation so as to transfer the workpiece by the connected carrier device into the designated process chamber;
wherein controlling the transfer actuator to perform the transfer-out action comprises:
   controlling the associated transfer actuator to drive the connected carrier device in the designated process chamber to move in translation so as to transfer the workpiece by the connected carrier device out of the designated process chamber; and
   controlling the chamber door of the designated process chamber to close.

In some embodiments, the semiconductor thermal processing apparatus comprises one or more braking mechanisms, wherein each of the braking mechanisms is arranged in a one-to-one correspondence with a carrier device; the method further comprises:
transmitting a braking signal to the braking mechanism when the carrier device is stationary, or after completion of a vertical movement, or in an abnormal state, so that the braking mechanism brakes the associated carrier device's vertical motion when receiving the braking signal; and
transmitting a braking release signal to the braking mechanism when the transfer-in instruction or the transfer-out instruction is received, so that the braking mechanism releases the braking of the associated carrier device when receiving the braking release signal.

The present disclosure has the advantageous effects as described in the following paragraphs.

According to the method for transferring workpieces by the carrier device using the disclosed semiconductor thermal processing apparatus, each of the carrier devices is in a one-to-one correspondence with one chamber group, and each of the transfer actuators is in a one-to-one correspondence with one carrier device. The transfer-in action or the transfer-out action executed by a transfer actuator is configured to transfer workpieces by a carrier device into or out of any one of the process chambers within the assigned chamber group. For a chamber group having multiple process chambers, a single transfer actuator and a single carrier device can be shared, there is no need to equip each of the process chambers with its own transfer actuator and carrier device. This can reduce structural redundancy and decrease overall energy consumption, as well as reducing equipment manufacturing and maintenance costs. On this basis, by using one controller communicatively connected to each of the transfer actuators and also communicatively connected to a host computer, the controller can control the transfer of multiple carrier devices, thereby realizing the "one-to-many" control. Specifically, the host computer may transmit, according to a preset scheduling method, a transfer-in instruction or a transfer-out instruction associated with a designated process chamber to the controller. The controller, based on the transfer-in or transfer-out instruction, controls the transfer actuator associated with the chamber group to which the designated process chamber belongs to perform the transfer-in action or the transfer-out action, namely, transferring the carrier device into or out of the designated process chamber within the associated chamber group. Compared with the related art, in which each subordinate controller independently and stepwise controls the transfer actuator associated with each of the process chambers, the present disclosure allows multiple process chambers to share one transfer actuator and one carrier device. Together with the preset scheduling method adopted by the host computer, the transfer-in or transfer-out action can be automatically completed according to the instruction issued by the host computer, without requiring the host computer to sequentially issue a series of commands for stepwise control. As a result, the degree of automation and scheduling efficiency can be effectively improved.

### BRIEF DESCRIPTION OF THE DRAWINGS

FIG. 1 is a schematic block diagram of a control device for a conventional cantilever paddle;
FIG. 2 is a schematic block diagram of a semiconductor thermal processing apparatus according to an embodiment of the present disclosure;
FIG. 3 is a schematic structural diagram of a transfer actuator according to an embodiment of the present disclosure;
FIG. 4 is a schematic diagram of a control gas circuit according to an embodiment of the present disclosure;
FIG. 5 is a diagram of a positional relationship between a locking cylinder in a braking state and a boat head according to an embodiment of the present disclosure;
FIG. 6 is a flowchart of a method for transferring workpieces by a carrier device of the semiconductor thermal processing apparatus according to an embodiment of the present disclosure;
FIG. 7 is a flowchart of a method for controlling a transfer actuator to perform a transfer-in action according to an embodiment of the present disclosure; and
FIG. 8 is a flowchart of a method for controlling a transfer actuator to perform a transfer-out action according to an embodiment of the present disclosure.

### DETAILED DESCRIPTION

In order to enable those skilled in the art to better understand the technical solutions of the present disclosure, the semiconductor thermal processing apparatus and the method for transferring workpieces by the carrier device thereof provided herein will be described in detail below with reference to the accompanying drawings.

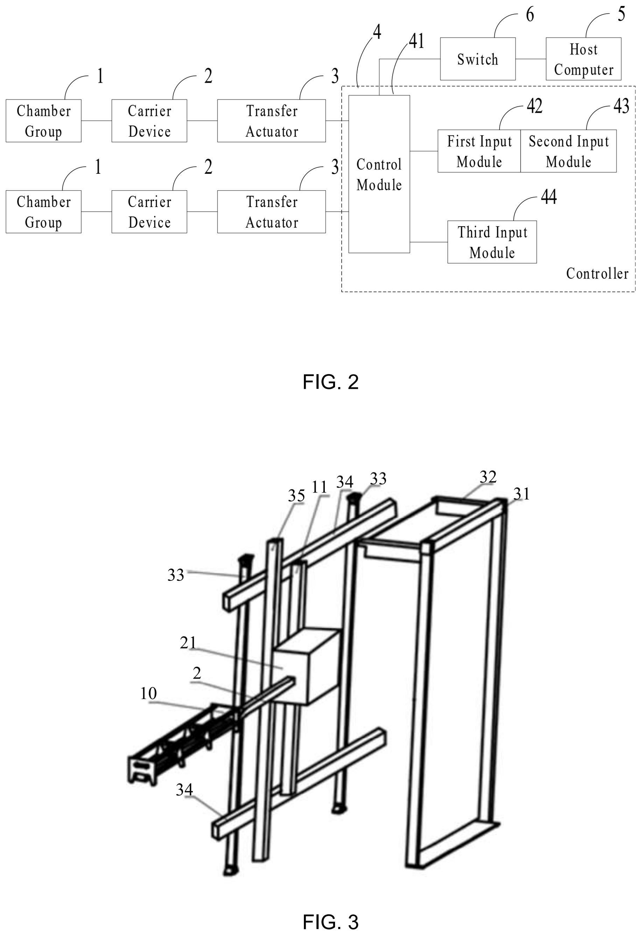

Referring to FIG. 2, in an embodiment of the present disclosure, a semiconductor thermal processing apparatus may be a diffusion furnace or another thermal processing apparatus. The semiconductor thermal processing apparatus includes: multiple process chambers (not shown in the figure), one or more carrier devices 2, one or more transfer actuators 3, a controller 4, and a host computer 5. The process chambers are divided into one or more chamber groups 1, each of the chamber groups 1 including one or more process chambers. A number of the process chambers in different chamber groups 1 may be the same or different. For example, in the case of a diffusion furnace, the number of the process chambers (also referred to as furnace tubes) is generally five or six. In this case, the process chambers may be divided into two chamber groups 1, each of the chamber groups 1 including two or three process chambers. Each of the process chambers usually has a chamber door (also referred to as a furnace door) that can be opened and closed. When the chamber door is opened, the carrier device 2 can be transferred into or out of the process chamber; when the chamber door is closed, the process chamber provides an enclosed space.

One or more carrier devices 2 are configured to carry workpieces to be processed. In the case of a diffusion furnace, each of the carrier devices 2 is generally a cantilever paddle. The workpieces to be processed, such as wafers, are typically loaded in a wafer boat, which is carried by the cantilever paddle. Each of the carrier devices 2 is in a one-to-one correspondence with one chamber group 1, that is, the process chambers in the same chamber group 1 share a single carrier device 2. This carrier device 2 can be transferred into or out of any process chamber in the assigned chamber group 1. For example, if the process chambers are divided into two chamber groups 1, then there are two carrier devices 2, the process chambers in each of the chamber groups can share one carrier device 2.

The number of transfer actuators 3 is the same as the number of the carrier devices 2, and each of the transfer actuators 3 is in a one-to-one correspondence with one carrier device 2. Each of the transfer actuator 3 is configured to drive the associated carrier device 2 to perform a transfer-in action or a transfer-out action, the transfer-in or transfer-out action being used to transfer the carrier device 2 into or out of any process chamber in the assigned chamber group 1. Specifically, the process chambers in the same chamber group 1 share one transfer actuator 3, and the transfer actuator 3 can transfer the associated carrier device 2 into or out of any process chamber in the assigned chamber group 1. For example, as shown in FIG. 2, if the process chambers are divided into two chamber groups 1, then two transfer actuators 3 are provided, with the process chambers in each of the chamber groups sharing one transfer actuator 3.

The controller 4 is communicatively connected to a transfer actuator 3, and is configured to receive a transfer-in instruction or a transfer-out instruction associated with a designated process chamber, and to control the transfer actuator 3 associated with the chamber group 1 to which the designated process chamber belongs to perform a transfer-in action or a transfer-out action according to the received instruction. The host computer 5 is communicatively connected to the controller 4, and is configured to transmit a transfer-in instruction or a transfer-out instruction to the controller 4 using a preset scheduling method. The controller 4 can control all the transfer actuators 3. The controller 4 may be, for example, a programmable logic controller (PLC), which can interact with the host computer 5 in real time. For example, the controller 4 and the host computer 5 may be communicatively connected through an EtherCAT bus (Ethernet for Control Automation Technology), with a switch 6 connected between the controller 4 and the host computer 5. The controller 4 and each of the transfer actuators 3 may also be communicatively connected through the EtherCAT bus.

In some embodiments, the controller 4 includes a first input module 42 and a control module 41. The first input module 42 is configured to receive first sensor feedback signals related to controlling the transfer actuators 3. The control module 41 is configured to control the transfer actuators 3 to perform a transfer-in action or a transfer-out action based on the first sensor feedback signals. Typically, sensors for detecting position, limits, and the like are provided on the transfer actuators 3 and the carrier devices 2. These sensors can transmit detected position information and in-place information of the transfer actuators 3 and the carrier devices 2 to the control module 41 through the first input module 42. The position information and the in-place information are collectively referred to as the first sensor feedback signals. The control module 41 can control the transfer actuators 3 to perform a transfer-in action or a transfer-out action based on the first sensor feedback signals.

In some embodiments, the controller 4 further includes a second input module 43, which is configured to receive second sensor feedback signals related to the opening and closing states of chamber doors of the process chambers. The control module 41 is further configured to control the chamber doors to perform opening and closing actions based on the second sensor feedback signals. Accordingly, the controller 4 can implement automatic control of the chamber doors. Limit sensors are provided at the chamber doors of the process chambers. These limit sensors can transmit detected door opening and closing state information to the control module 41 through the second input module 43. The opening and closing state information constitutes the second sensor feedback signals described above. In addition, in one example, the controller 4 may further include a third input module 44, which is configured to receive acquisition signals of the overall system. The acquisition signals may include, for example, a CDA (Cylinder Down) signal of the chamber doors, an EMO (Emergency Off, normally closed) signal, a silence signal, and the like. The control module 41 is further configured to perform logical outputs including buzzer control and alarm tower light control when receiving the acquisition signals.

The host computer 5 may be used as a human-machine interaction interface. Through real-time interaction with the controller 4, the host computer 5 can monitor motion information of the carrier devices 2 and door information of the furnaces. Such information specifically includes the position, speed, and limit states of the carrier devices 2, as well as the state of the furnace doors. During debugging, the host computer 5 can also be used for program optimization and configuration parameter modification. During the transfer control process of the carrier devices 2, the host computer 5 is configured to transmit a transfer-in instruction or a transfer-out instruction to the controller 4 using a preset scheduling method. The preset scheduling method is configured to coordinate the carrier devices 2 so as to achieve efficient scheduling of movements of the carrier devices 2, on the basis that each of the carrier devices 2 can be transferred into or out of any one of the process chambers within an assigned chamber group.

In some embodiments, the semiconductor thermal processing apparatus may further include multiple subordinate controllers, each in a one-to-one correspondence with a respective process chamber. Each of the subordinate controllers is configured to receive sensor feedback signals related to execution of processes in the associated process chamber, and also to receive the first sensor feedback signals and the second sensor feedback signals sent by the controller 4. Each of the subordinate controllers may also be configured to control the process chamber to perform a process according to a command, related to process execution, issued by the upper-level controller 5. That is, the controller 4 and the subordinate controllers in the embodiments of the present disclosure have their respective control objects and execute different instructions. The controller 4 is used to execute transfer-in instructions or transfer-out instructions, while the subordinate controllers are used to execute commands related to process execution. Moreover, the controller 4 and the subordinate controllers acquire different sensor feedback signals. The controller 4 is used to acquire the first and second sensor feedback signals described above, whereas the subordinate controllers acquire sensor feedback signals related to process execution of the process chambers.

In the semiconductor thermal processing apparatus provided in the embodiments of the present disclosure, each of the carrier devices 2 is in a one-to-one correspondence with one chamber group 1, and each of the transfer actuators 3 is in a one-to-one correspondence with one carrier device 2. The transfer-in operation or transfer-out operation executed by the transfer actuator 3 is used to transfer the carrier device 2 into or out of any process chamber in the assigned chamber group. For the chamber group 1 including multiple process chambers, a single transfer actuator 3 and carrier device 2 can be shared, without the need to equip each of the process chambers with a transfer actuator 3 and a carrier device 2, thereby reducing structural redundancy, lowering overall energy consumption, and reducing equipment manufacturing and maintenance costs. On this basis, by using one controller 4 communicatively connected to each of the transfer actuators 3 and also communicatively connected to a host computer 5, the controller 4 can control the transfer of multiple carrier devices 2, thereby realizing "one-to-many" control. Specifically, the host computer 5 may transmit, according to a preset scheduling method, a transfer-in instruction or a transfer-out instruction associated with a designated process chamber to the controller 4. The controller 4, based on the transfer-in or transfer-out instruction, controls the transfer actuator 3 assigned to the chamber group 1 to which the designated process chamber belongs to perform the transfer-in action or the transfer-out action, namely, transferring the carrier device 2 into or out of the designated process chamber within the assigned chamber group 1. Compared with the related art, in which each subordinate controller independently and stepwise controls the transfer actuator associated with each of the process chambers, the present disclosure allows multiple process chambers to share one transfer actuator 3 and one carrier device 2. Together with the preset scheduling method adopted by the host computer 5, the transfer-in or transfer-out action can be automatically completed according to the instruction issued by the host computer 5, without requiring the host computer 5 to sequentially issue a series of commands for stepwise control. As a result, the degree of automation and scheduling efficiency can be effectively improved.

In some embodiments, multiple process chambers are sequentially arranged in a vertical direction. In this case, the transfer actuator 3 is configured to drive an associated carrier device 2 to move vertically, so as to move the carrier device 2 to a height position associated with any process chamber in the chamber group 1. The transfer actuator 3 is further configured to drive the carrier device 2 located at the height position to move in a horizontal direction, so as to transfer the carrier device 2 into or out of the process chamber. Taking a horizontal diffusion furnace as an example, multiple process chambers are sequentially arranged in the vertical direction, and a chamber door of each of the process chambers is located at one side of the process chamber in the horizontal direction. In this case, by means of a transfer actuator 3 driving an associated carrier device 2 to move vertically, the carrier device 2 can be selectively moved to the height position associated with any process chamber in the chamber group 1, that is, the carrier device 2 and one of the process chambers are located at the same height, thereby being opposite to the chamber door of the process chamber. On this basis, in a state where the chamber door is opened, by means of the transfer actuator 3 driving the carrier device 2 located at the height position to move in the horizontal direction, the carrier device 2 can be transferred into the process chamber, or the carrier device 2 in the process chamber can be transferred out.

The transfer actuator 3 for realizing the above function may have various structures. For example, as shown in FIG. 3, each of the transfer actuators 3 includes: a lifting drive assembly 35, a horizontal drive assembly 34, a loading/unloading mechanical arm, and a drive assembly configured to drive the loading/unloading mechanical arm to move vertically and horizontally. The lifting drive assembly 35 is connected to the associated carrier device 2 and is configured to drive the associated carrier device 2 to move vertically. The horizontal drive assembly 34 is connected to the lifting drive assembly 35 and is configured to drive the lifting drive assembly 35 and the carrier device 2 to move horizontally in synchronization. The loading/unloading mechanical arm is configured, under the driving of the drive assembly, to load or unload a workpiece to be processed from the carrier device 2, for example, to load or unload a wafer boat 10 carrying wafers from the cantilever paddle 2. In a specific embodiment, the lifting drive assembly 35 includes a lifting driver and a lifting motor, wherein the lifting motor is operatively connected to the carrier device 2 through a transmission assembly. Rotational power provided by the lifting motor is converted by the transmission assembly into linear power in the vertical direction and transmitted to the carrier device 2. The transmission assembly may, for example, include a screw rod and a nut in threaded engagement. The screw rod is vertically arranged, and the lifting motor is configured to drive the screw rod to rotate so as to drive the nut to move along the screw rod. The nut is connected to the carrier device 2, for example, connected to the boat head 21 of the cantilever paddle 2. The lifting driver is configured to perform information interaction and signal conversion with the controller 4, for example, to convert a control signal from the controller 4 so as to control the lifting motor to perform an operation. The lifting driver and the lifting motor may, for example, be a servo driver and a servo motor.

The horizontal drive assembly 34 may be fixed to the frame 33. The horizontal drive assembly 34 may be one or more; for example, two horizontal drive assemblies 34 are illustrated in FIG. 3. The two horizontal drive assemblies 34 are arranged opposite to each other in the vertical direction and are connected to the lifting drive assembly 35 at positions near both ends thereof, so as to jointly drive the lifting drive assembly 35 to move horizontally. Specifically, the horizontal drive assembly 34 includes a horizontal driver and a horizontal motor, wherein the horizontal motor is operatively connected to the carrier device 2 through a transmission assembly. Rotational power provided by the horizontal motor is converted by the transmission assembly into linear power in the horizontal direction and transmitted to the lifting drive assembly 35. The transmission assembly may, for example, include a transmission belt. The horizontal driver is configured to perform information interaction and signal conversion with the controller 4, for example, to convert a control signal from the controller 4 so as to control the horizontal motor to perform an operation. The horizontal driver and the horizontal motor may, for example, be a servo driver and a servo motor.

The drive assembly for driving the loading/unloading robotic arm to move vertically and horizontally may, for example, include a lifting electric cylinder 31 and two horizontal motors 32, wherein the lifting electric cylinder 31 is connected to the two horizontal motors 32 to drive the two horizontal motors 32 to move synchronously in the vertical direction. The two horizontal motors 32 are connected to the loading/unloading robotic arm at positions near both ends thereof so as to jointly drive the loading/unloading robotic arm to move horizontally, thereby enabling loading or unloading of a workpiece to be processed from the carrier device 2. For example, when the loading/unloading robotic arm is translated to a retracted position (near the lifting electric cylinder 31), the workpiece to be processed (e.g., a wafer boat) can be loaded or unloaded on the robotic arm. When the loading/unloading robotic arm is translated to an extended position (away from the lifting electric cylinder 31), the robotic arm can load or unload the workpiece to be processed (e.g., a wafer boat) onto or from the carrier device 2 (e.g., a cantilever paddle). The two horizontal motors 32 are operatively connected to the loading/unloading robotic arm through a transmission assembly. Rotational power provided by the horizontal motors 32 is converted by the transmission assembly into linear power in the horizontal direction and transmitted to the loading/unloading robotic arm. In addition, reciprocal horizontal movement of the loading/unloading robotic arm can be achieved by switching the two horizontal motors 32 between forward and reverse rotation.

In some embodiments, the semiconductor thermal processing apparatus further includes one or more braking mechanisms, wherein each of the braking mechanisms 11 is in a one-to-one correspondence with one carrier device 2. The braking mechanism 11 is configured to brake the associated carrier device 2 when receiving a braking signal, and to release the braking of the associated carrier device 2 when receiving a braking release signal. The controller 4 is further configured to transmit the braking signal or the braking release signal to the braking mechanism 11. With the braking mechanism 11, in combination with the use of the controller 4, a safe interlock control of the carrier device 2 can be realized.

For the case where multiple process chambers are sequentially arranged along the vertical direction, a carrier device 2 shared by multiple process chambers has a relatively long vertical travel. There may exist a safety risk of the carrier device 2 falling due to failures such as switch (e.g., brake) malfunction. In this regard, the braking mechanism 11 is configured to brake the vertical motion of the associated carrier device 2 when receiving the braking signal, thereby preventing the carrier device 2 from dropping the workpieces.

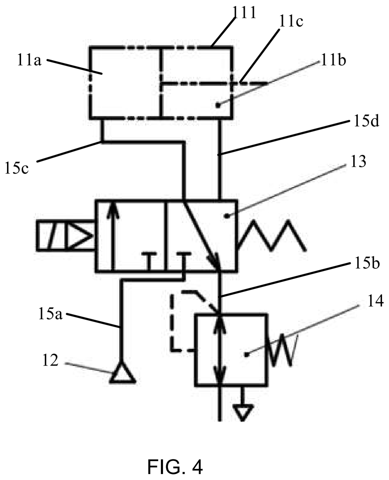

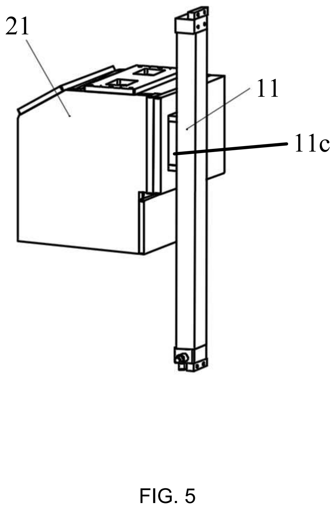

There are various types of braking mechanisms 11 for implementing the above functions. For example, as shown in FIG. 4 and FIG. 5, the braking mechanism 11 includes a locking cylinder 111, a clamp (not shown in the figures), and a control air circuit. The clamp is connected to a piston rod 11c of the locking cylinder 111 and is configured, when the piston rod 11c extends from the locking cylinder 111, to brake the associated carrier device 2. For instance, as shown in FIG. 5, taking the carrier device 2 as a cantilever paddle as an example, when the piston rod 11c extends from the locking cylinder 111, the piston rod 11c extends into the boat head 21 of the cantilever paddle to block the lifting of the cantilever paddle. Meanwhile, the clamp may extend into the travel path of the lifting drive assembly to block the operation of the lifting drive assembly. In practical applications, the locking cylinder 111 and the clamp may adopt any braking structure, and the embodiments of the present disclosure are not particularly limited in this regard. When the piston rod 11c retracts, the braking of the associated carrier device 2 is released. The control air circuit is connected to the locking cylinder 111 and is configured, when receiving a braking signal, to supply air to the locking cylinder 111 so as to cause the piston rod 11c to extend from the locking cylinder 111, and, when receiving a braking release signal, to discharge the gas in the locking cylinder 111 so as to cause the piston rod 11c to retract. In one example, both the movement of the piston rod 11c of the above locking cylinder 111 and the braking action of the clamp can be controlled by the controller 4. That is, the braking signal includes a clamping signal of the clamp and a locking signal of the locking cylinder 111. When the locking cylinder 111 receives the locking signal output from the controller 4, and the clamp receives the clamping signal output from the controller 4, the piston rod 11c extends from the locking cylinder 111, and the clamp brakes the vertical motion of the associated carrier device 2. The brake release signal includes a clamp release signal and a lock cylinder 111 release signal. When the lock cylinder 111 receives the lock cylinder 111 release signal output by the controller 4 and the clamp receives the clamp release signal output by the controller 4, the clamp releases the associated carrier device 2 from braking, and the piston rod 11c retracts. By controlling the movement of the piston rod 11c of the locking cylinder 111 and the braking action of the clamp, the controller 4 can provide dual protection against falling of the carrier device 2.

In some embodiments, the controller 4 may determine the motion state of the carrier device 2 based on the feedback signal of the above first sensor. When the carrier device 2 is stationary, or after completing the vertical movement, or in an abnormal state, the controller 4 can output the braking signal to prevent the carrier device 2 from falling. Furthermore, the locking cylinder 111 may also feed back position information to the controller 4. For example, after the controller 4 outputs a braking signal, when receiving the in-place feedback signal fed back from the locking cylinder 111, the controller 4 may feed back to the host computer 5 the information indicating that the carrier device 2 is in a locked state in the vertical direction. This allows the host computer 5 to display such information on the human-machine interface, and also enables the host computer 5 to perform software logic interlocking. When the controller 4 receives a transfer-in instruction or a transfer-out instruction from the host computer 5, the controller 4 outputs a braking release signal and feeds back to the host computer 5 the information indicating that the carrier device 2 is in an unlocked state in the vertical direction, so that the host computer 5 can display such information on the human-machine interface. In one example, after outputting the braking release signal, the controller 4 is further configured to determine whether a current state of the carrier device 2 satisfies a preset interlock condition. If the condition is satisfied, the associated transfer actuator 3 is controlled to perform a transfer-in action or a transfer-out action.

In a specific embodiment, as shown in FIG. 4, an interior of the locking cylinder 111 is divided by a piston rod 11c into a first air chamber 11a and a second air chamber 11b, and one end of the piston rod 11c passes through the second air chamber 11b and extends out of the locking cylinder 111. The above control air circuit includes a directional valve 13, a relief valve 14, and an air source 12. The air source 12 is connected to the directional valve 13 through a first air line 15a, the relief valve 14 is connected to the directional valve 13 through a second air line 15b, and the directional valve 13 is connected to the first air chamber 11a and the second air chamber 11b through a third air line 15c and a fourth air line 15d, respectively. The directional valve 13 switches to a first state when receiving a braking signal, and switches to a second state when receiving a braking release signal. In the first state, the directional valve 13 connects the first air line 15a with the third air line 15c, and disconnects the second air line 15b from the fourth air line 15d. In the second state, the directional valve 13 connects the second air line 15b with the third air line 15c, and disconnects the first air line 15a from the fourth air line 15d. The directional valve 13 illustrated in FIG. 4 is in the second state.

In some embodiments, the controller 4 may further switch among an automatic mode, a manual mode, and a program function mode. In the automatic mode, when the controller 4 receives a transfer-in instruction or a transfer-out instruction from the host computer 5, it may automatically control the associated transfer actuator 3 to perform the transfer-in action or the transfer-out action. In the manual mode, the controller 4 may control the associated transfer actuator 3 to perform an action associated with the instruction issued by a user through the host computer 5, for example, servo control of the lifting drive assembly 35 and the horizontal drive assembly 34 of the transfer actuator 3, including enabling, resetting, returning to the origin, speed control, position control, and other functions. In the program function mode, the controller 4 may perform automatic or semi-automatic logic control of partial actions, such as automatic loading, automatic unloading, semi-automatic loading, semi-automatic unloading, and opening or closing of the chamber door.

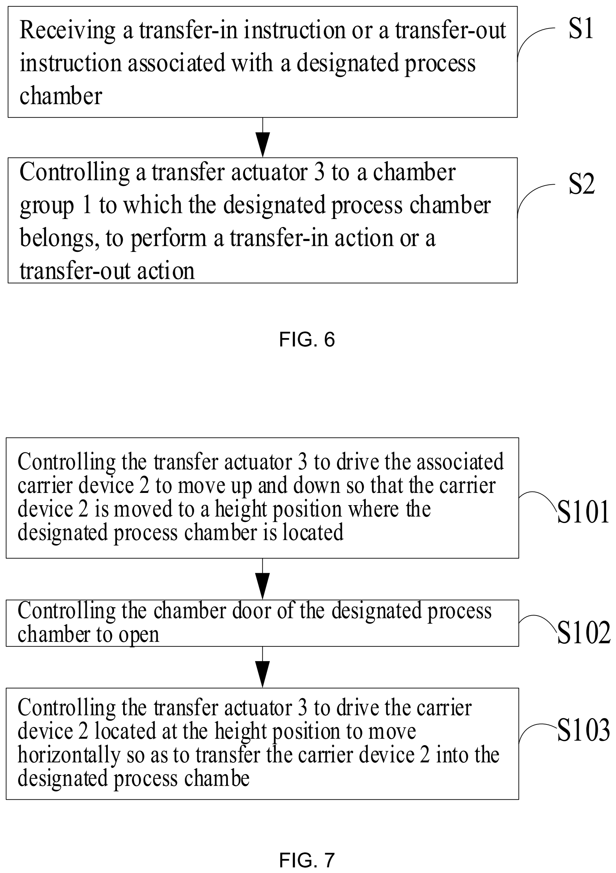

As another technical solution, the present disclosure further provides a method for transferring workpieces by a carrier device of a semiconductor thermal processing apparatus, the semiconductor thermal processing apparatus being the semiconductor thermal processing apparatus provided in the above embodiments of the present disclosure. Please refer to FIG. 6, the method includes:
S1: receiving a transfer-in instruction or a transfer-out instruction associated with a designated process chamber; and
S2: controlling a transfer actuator 3 to a chamber group 1 to which the designated process chamber belongs, to perform a transfer-in action or a transfer-out action;
wherein the transfer-in action or the transfer-out action is configured to transfer a carrier device 2, which is used for carrying a workpiece to be processed, into or out of the designated process chamber within the assigned chamber group 1.

The selection of the above designated process chamber may be implemented by the host computer 5 using a preset scheduling method.

The method for transferring workpieces by the carrier device provided in the embodiments of the present disclosure can, based on a transfer-in instruction or a transfer-out instruction associated with a designated process chamber, control the transfer actuator 3 assigned to the chamber group 1 to which the designated process chamber belongs to perform a transfer-in action or a transfer-out action. That is, the carrier device 2 is transferred into or out of the designated process chamber in the associated chamber group 1. Compared with the related art, in which each subordinate controller independently and step-by-step controls the transfer actuator associated with each of the process chambers, the present disclosure enables multiple process chambers to share one transfer actuator and one carrier device. In this case, combined with a preset scheduling method adopted by the host computer, the transfer-in or transfer-out action can be automatically completed according to the instruction issued by the host computer, without requiring the host computer to issue a series of commands step by step, thereby effectively improving the degree of automation and scheduling efficiency.

In some embodiments, multiple process chambers are sequentially arranged along the vertical direction. In this case, as shown in FIG. 7, the method for controlling the transfer actuator 3 to perform the transfer-in action includes:
S101: controlling the transfer actuator 3 to drive the associated carrier device 2 to move vertically so that the carrier device 2 is moved to a height position where the designated process chamber is located;
step S101 is executed when receiving the transfer-in instruction associated with the designated process chamber, and the transfer actuator 3 corresponds to the chamber group to which the designated process chamber belongs.
S102: controlling the chamber door of the designated process chamber to open;
S103: controlling the transfer actuator 3 to drive the carrier device 2 located at the height position to move horizontally so as to transfer the carrier device 2 into the designated process chamber.

In some embodiments, after the above step S103, the method further includes:
S104: controlling the transfer actuator 3 to drive the carrier device 2 in the process chamber to move vertically so that the carrier device 2 is positioned at a material-taking or material-feeding position.

The above transfer-in action is thereby completed.

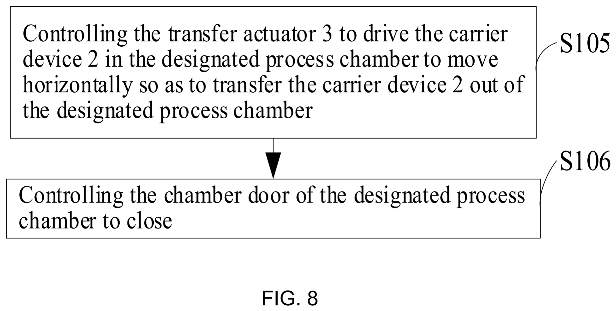

In some embodiments, as shown in FIG. 8, the method for controlling the transfer actuator 3 to perform the transfer-out action includes:
S105: controlling the transfer actuator 3 to drive the carrier device 2 in the designated process chamber to move horizontally so as to transfer the carrier device 2 out of the designated process chamber;
step S105 is executed when receiving the transfer-out instruction associated with the designated process chamber, and the transfer actuator 3 corresponds to the chamber group to which the designated process chamber belongs.
S106: controlling the chamber door of the designated process chamber to close.

The above transfer-out action is thereby completed.

In a specific embodiment, when receiving a transfer-in instruction associated with a designated process chamber, the origin position information of the transfer actuator 3 is first acquired. The origin position information may be, for example, the origin positions of the servo motors of the lifting drive assembly 35 and the horizontal drive assembly 34 within the transfer actuator 3. Next, after determining that the transfer actuator 3 has completed the previous operation, the current position information of the transfer actuator 3 is acquired. According to the current position information, the transfer actuator 3 may be in one of the following two cases. A first case is that the transfer actuator 3 is located at the height position of one of the process chambers (which may be either inside or outside the process chamber). A second case is that the transfer actuator 3 is located at a safety position, the safety position being an extreme position in the translation direction away from the process chamber.

In the above first case, the horizontal drive assembly 34 may be controlled to drive the carrier device 2 to translate, so as to transfer the carrier device 2 into or out of the process chamber. During this process, once a torque alarm signal or a limit-position alarm signal is received, the horizontal drive assembly 34 is immediately controlled to stop operation. A torque sensor is provided on the horizontal drive assembly 34 for detecting whether torque is generated, and a position sensor is provided for detecting whether the translation motor reaches a forward or reverse limit position. These two sensors feed back the above torque alarm signal or limit-position alarm signal. When the in-position signal fed back by the horizontal drive assembly 34 is received, a signal indicating completion of the operation is sent to the host computer 5. An encoder is provided on the translation motor of the horizontal drive assembly 34 to determine whether the carrier device 2 has reached the target position. The encoder feeds back the above in-position signal. In addition, in the above first case, if a new transfer-in instruction or transfer-out instruction associated with another process chamber is received, it is determined whether the current position of the transfer actuator 3 is located at the safety position. If yes, the new transfer-in instruction or transfer-out instruction is executed; if no, the horizontal drive assembly 34 is controlled to drive the carrier device 2 to translate to the safety position.

In the above second case, the lifting drive assembly 35 may be controlled to drive the carrier device 2 to move vertically. During this process, once a torque alarm signal or a limit-position alarm signal is received, the lifting drive assembly 35 is immediately controlled to stop operation. A torque sensor is provided on the lifting drive assembly 35 for detecting whether torque is generated, and a position sensor is provided for detecting whether the lifting motor reaches a forward or reverse limit position. These two sensors feed back the above torque alarm signal or limit-position alarm signal. When the in-position signal fed back by the lifting drive assembly 35 is received, a signal indicating completion of the operation is sent to the host computer 5. An encoder is provided on the lifting motor of the lifting drive assembly 35 to determine whether the carrier device 2 has reached the target position. The encoder feeds back the above in-position signal. In addition, when the lifting drive assembly 35 is controlled to drive the carrier device 2 to move vertically, if the transfer actuator 3 fails to reach the height position of the designated process chamber within a preset time, a position deviation alarm signal is sent to the host computer 5, so that the host computer 5 may perform operations such as a pop-up prompt. Further, in the above second case, if a new transfer-in instruction or transfer-out instruction associated with another process chamber is received, the new transfer-in instruction or transfer-out instruction is executed after the current transfer-in instruction or transfer-out instruction is completed and after the transfer actuator 3 is located at the safety position.

In some embodiments, before controlling the transfer actuator 3 to drive the associated carrier device 2 to move vertically, the method further includes:
determining whether the transfer actuator 3 has reached the safety position within a preset time, where the safety position is a limit position in the translation direction at which the transfer actuator 3 is away from the process chamber;
if yes, controlling the transfer actuator 3 to drive the associated carrier device 2 to move vertically;
if no, issuing a position deviation alarm signal.

In this way, it can be ensured that the carrier device 2 is driven to move vertically only on the premise that it is located outside the process chamber.

In some embodiments, in the case where multiple process chambers are sequentially arranged in the vertical direction, for the carrier device 2 shared by the multiple process chambers, its movement stroke in the vertical direction is relatively long. There may be a safety risk of the carrier device 2 falling due to reasons such as failure of a switch (e.g., a brake). In this regard, the semiconductor thermal processing apparatus may further include one or more braking mechanisms; each of the braking mechanisms is provided in a one-to-one correspondence with the carrier device 2, and is configured to brake the vertical motion of the associated carrier device 2 when receiving a braking signal, and to release the brake of the associated carrier device 2 when receiving a brake release signal. The method for transferring workpieces by the carrier device 2 provided by the present disclosure further includes:
transmitting a braking signal to the braking mechanism when the carrier device 2 is stationary, or after completion of a vertical movement, or in an abnormal state, so that the braking mechanism brakes the associated carrier device 2'svertical motion when receiving the braking signal; and
transmitting a braking release signal to the braking mechanism when the transfer-in instruction or the transfer-out instruction is received, so that the braking mechanism releases the braking of the associated carrier device 2 when receiving the braking release signal.

In one example, the movement state of the carrier device 2 can be determined based on the received first sensor feedback signal. When the carrier device 2 is stationary, or after completing the vertical movement, or in an abnormal state, the controller 4 can output the braking signal to prevent the carrier device 2 from falling.

The braking mechanism may include, for example, a lock cylinder 111, a clamp, and a control air circuit. The structures and functions of these components have been described in detail in the above embodiments and are not repeated herein. In some embodiments, the braking signal includes a clamp clamping signal and a lock cylinder 111 locking signal. When the lock cylinder 111 receives the lock cylinder 111 locking signal output by the controller 4 and the clamp receives the clamp clamping signal output by the controller 4, the piston rod 11c extends from the lock cylinder 111, and the clamp brakes the vertical motion of the associated carrier device 2. The brake release signal includes a clamp release signal and a lock cylinder 111 release signal. When the lock cylinder 111 receives the lock cylinder 111 release signal output by the controller 4 and the clamp receives the clamp release signal output by the controller 4, the clamp releases the associated carrier device 2 from braking, and the piston rod 11c retracts. By controlling the movement of the piston rod 11c of the lock cylinder 111 and the clamping action of the clamp, dual protection against the falling of the carrier device 2 can be achieved.

In summary, in the semiconductor thermal processing apparatus provided in the embodiments of the present disclosure, each of the carrier devices 2 is in a one-to-one correspondence with one chamber group 1, and each of the transfer actuators 3 in a one-to-one correspondence with one carrier device 2. The transfer-in operation or transfer-out operation executed by the transfer actuator 3 is used to transfer the carrier device 2 into or out of any process chamber in the associated chamber group. For the chamber group 1 including multiple process chambers, a single transfer actuator 3 and carrier device 2 can be shared, without the need to equip each of the process chambers with a transfer actuator 3 and a carrier device 2, thereby reducing structural redundancy, lowering overall energy consumption, and reducing equipment manufacturing and maintenance costs. On this basis, by using one controller 4 communicatively connected to each of the transfer actuators 3 and also communicatively connected to a host computer 5, the controller 4 can control the transfer of multiple carrier devices 2, thereby realizing "one-to-many" control. Specifically, the host computer 5 may transmit, according to a preset scheduling method, a transfer-in instruction or a transfer-out instruction associated with a designated process chamber to the controller 4. The controller 4, based on the transfer-in or transfer-out instruction, controls the transfer actuator 3 assigned to the chamber group 1 to which the designated process chamber belongs to perform the transfer-in action or the transfer-out action, namely, transferring the carrier device 2 into or out of the designated process chamber within the assigned chamber group 1. Compared with the related art, in which each subordinate controller independently and stepwise controls the transfer actuator associated with each of the process chambers, the present disclosure allows multiple process chambers to share one transfer actuator 3 and one carrier device 2. Together with the preset scheduling method adopted by the host computer 5, the transfer-in or transfer-out action can be automatically completed according to the instruction issued by the host computer 5, without requiring the host computer 5 to sequentially issue a series of commands for stepwise control. As a result, the degree of automation and scheduling efficiency can be effectively improved.

It should be understood that the above embodiments are merely exemplary implementations used to illustrate the principles of the present disclosure, and the present disclosure is not limited thereto. For those of ordinary skill in the art, various modifications and improvements can be made without departing from the spirit and essence of the present disclosure, and such modifications and improvements are also considered to fall within the scope of the present disclosure.

## Claims

1. A semiconductor thermal processing apparatus, comprising:
process chambers, wherein the process chambers are assigned into one or more chamber groups;
one or more carrier devices configured to carry a workpiece to be processed, wherein each of the carrier devices is in a one-to-one correspondence with one of the chamber groups;
one or more transfer actuators, wherein each of the transfer actuators is in a one-to-one correspondence with one associated carrier device and is configured to drive the associated carrier device to perform a transfer-in action or a transfer-out action; wherein the transfer-in action or the transfer-out action is configured to transfer, by the connected carrier device, the workpiece into or out of one of the process chambers from its assigned chamber group;
a controller communicatively connected to the transfer actuators, wherein the controller is configured to receive a transfer-in instruction or a transfer-out instruction to a designated process chamber which is assigned to one of the chamber groups, and to control the associated transfer actuator, so as to perform the transfer-in action or the transfer-out action by the connected carrier device according to the transfer-in instruction or the transfer-out instruction; and
a host computer communicatively connected to the controller, wherein the host computer is configured to transmit the transfer-in instruction or the transfer-out instruction to the controller using a preset scheduling method.

2. The semiconductor thermal processing apparatus according to claim 1, further comprising:
one or more braking mechanisms, wherein each of the braking mechanisms is arranged in a one-to-one correspondence with a carrier device, and configured to brake a motion of the associated carrier device through the connected transfer actuator when receiving a braking signal, and to release the braking of the associated carrier device through the connected transfer actuator when receiving a braking release signal; and
wherein the controller is further configured to transmit the braking signal or the braking release signal to the braking mechanisms.

3. The semiconductor thermal processing apparatus according to claim 2, wherein each of the braking mechanisms comprises:
a locking cylinder;
a clamp connected to a piston rod of the locking cylinder, wherein the clamp is configured to brake the associated carrier device when the piston rod extends out from the locking cylinder, and to release the braking of the associated carrier device when the piston rod retracts; and
a control air circuit connected to the locking cylinder, wherein the control air circuit is configured to supply air to the locking cylinder when receiving the braking signal so as to extend out the piston rod from the locking cylinder, and to discharge air from in the locking cylinder when receiving the braking release signal so as to retract the piston rod.

4. The semiconductor thermal processing apparatus according to claim 3, wherein an interior of the locking cylinder is divided by the piston rod into a first air chamber and a second air chamber, and one end of the piston rod passes through the second air chamber and extends out of the locking cylinder;
wherein the control air circuit comprises:
a directional valve,
a relief valve,
and an air source,
wherein the air source is connected to the directional valve through a first air line, the relief valve is connected to the directional valve through a second air line, and the directional valve is connected to the first air chamber through a third air line, and to the second air chamber through a fourth air line, respectively; and
wherein the directional valve is configured to:
switch to a first state when receiving the braking signal, and switch to a second state when receiving the braking release signal;
in the first state, the directional valve connects the first air line to the third air line and disconnects the second air line from the fourth air line; in the second state, the directional valve connects the second air line to the third air line and disconnects the first air line from the fourth air line.

5. The semiconductor thermal processing apparatus according to any one of claims 2-4, wherein the process chambers are sequentially arranged along a vertical direction;
wherein each of the transfer actuators is configured to drive the connected carrier device to move vertically so as to reach a height position aligned with one of the process chambers assigned to one of the chamber groups, and
wherein each of the transfer actuators is further configured to drive the connected carrier device located at the reached height position to move horizontally so as to transfer the workpiece by the connected carrier device into or out of the designated process chamber; and
wherein the braking mechanism is configured to brake a vertical motion of the associated carrier device when receiving the braking signal.

6. The semiconductor thermal processing apparatus according to claim 5, wherein each of the transfer actuators comprises:
a lifting drive assembly connected to the connected carrier device and configured to drive the connected carrier device to move vertically;
a horizontal drive assembly connected to the lifting drive assembly and configured to drive the lifting drive assembly and the connected carrier device to move horizontally in synchronization; and
a loading and unloading mechanical arm and a drive assembly configured to drive the loading and unloading mechanical arm to move vertically and horizontally, wherein the loading and unloading mechanical arm is configured to load or unload the workpiece from the connected carrier device under a control of the drive assembly.

7. The semiconductor thermal processing apparatus according to claim 1, wherein the controller comprises:
a first input module configured to receive first sensor feedback signals related to controlling the transfer actuators; and
a control module configured to control the transfer actuators to perform the transfer-in action or the transfer-out action according to the first sensor feedback signals;

8. The semiconductor thermal processing apparatus according to claim 7, wherein the controller further comprises:
a second input module configured to receive second sensor feedback signals related to a door opening state or a door closing state of each of the process chambers;
the control module further configured to control the chamber door to perform an opening or closing action according to the second sensor feedback signals.

9. A method for transferring workpieces by the carrier device of the semiconductor thermal processing apparatus, according to any one of claims 1 to 8, the method comprising:
receiving the transfer-in instruction or the transfer-out instruction associated with the designated process chamber; and
controlling the transfer actuator connected to the designated process chamber assigned to the chamber group to perform the transfer-in action or the transfer-out action according to the transfer-in instruction or the transfer-out instruction.

10. The method according to claim 9, wherein the process chambers are sequentially arranged in a vertical direction;
wherein controlling the transfer actuator to perform the transfer-in action comprises:
controlling the transfer actuator to drive the connected carrier device to move vertically to reach a height position aligned with the designated process chamber; and
controlling the chamber door of the designated process chamber to open; and controlling the associated transfer actuator to drive the connected carrier device located at the height position to move in translation so as to transfer the workpiece by the connected carrier device into the designated process chamber;
wherein controlling the associated transfer actuator to perform the transfer-out action comprises:
controlling the associated transfer actuator to drive the connected carrier device in the designated process chamber to move in translation so as to transfer the workpiece by the connected carrier device out of the designated process chamber; and
controlling the chamber door of the designated process chamber to close.

11. The method according to claim 10, wherein the semiconductor thermal processing apparatus comprises one or more braking mechanisms, wherein each of the braking mechanisms is arranged in a one-to-one correspondence with a carrier device, and is associated with one carrier device; the method further comprises:
transmitting a braking signal to the braking mechanism when the carrier device is stationary, or after completion of a vertical movement, or in an abnormal state, so that the braking mechanism brakes a vertical motion of the associated carrier device when receiving the braking signal; and
transmitting a braking release signal to the braking mechanism when the transfer-in instruction or the transfer-out instruction is received, so that the braking mechanism releases the braking of the associated carrier device when receiving the braking release signal.
